(19) Europäisches Patentamt
European Patent Office
Office européen des brevets

(11) **EP 4 350 970 A1**

(12) **EUROPÄISCHE PATENTANMELDUNG**

(43) Veröffentlichungstag:
**10.04.2024   Patentblatt 2024/15**

(21) Anmeldenummer: **22200303.0**

(22) Anmeldetag: **07.10.2022**

(51) Internationale Patentklassifikation (IPC):
**H02P 3/18** (2006.01)    **H02P 6/182** (2016.01)
**H02P 23/14** (2006.01)

(52) Gemeinsame Patentklassifikation (CPC):
**H02P 3/18; H02P 6/182; H02P 23/14**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **dormakaba Deutschland GmbH
58256 Ennepetal (DE)**

(72) Erfinder: **Böse, Dennis
58256 Ennepetal (DE)**

(74) Vertreter: **Balder IP Law, S.L.
Paseo de la Castellana 93
5ª planta
28046 Madrid (ES)**

(54) **VERFAHREN ZUR BESTIMMUNG MINDESTENS EINER EIGENSCHAFT EINER DREHBEWEGUNG EINER DREIPHASIGEN DREHSTROMMASCHINE IM GENERATORBETRIEB UND ELEKTROMECHANISCHER ANTRIEB**

(57)    Die Erfindung betrifft ein Verfahren zur Bestimmung mindestens einer Eigenschaft einer Drehbewegung einer dreiphasigen Drehstrommaschine im Generatorbetrieb, wobei für jede der drei Phasen jeweils eine elektrische Kenngröße für eine Phasenspannung (1, 2, 3) der betreffenden Phase der im Generatorbetrieb erzeugten dreiphasigen Wechselspannung der Drehstrommaschine fortlaufend messtechnisch erfasst wird. Aus den drei elektrischen Kenngrößen werden drei elektrische Kenngrößenpaare gebildet werden, sodass ein erstes elektrisches Kenngrößenpaar die elektrischen Kenngrößen einer ersten und einer zweiten Phase umfasst, ein zweites elektrisches Kenngrößenpaar die elektrischen Kenngrößen der zweiten Phase und einer dritten Phase umfasst und ein drittes elektrisches Kenngrößenpaar die elektrischen Kenngrößen der dritten Phase und der ersten Phase umfasst. Fortlaufend wird jeweils ein Vorzeichen einer Differenz zwischen den elektrischen Kenngrößen jedes Kenngrößenpaars ermittelt. Die Eigenschaft der Drehbewegung wird aus Wechselzeitpunkten $(t\_4,1, t\_4,2, t\_4,3,..., t\_5,1, t\_5,2, t\_5,3,..., t\_6,1, t\_6,2, t\_6,3,...)$ ermittelt, wobei die Wechselzeitpunkte Zeitpunkten unmittelbar aufeinanderfolgender Vorzeichenwechsel der Differenzen der drei Kenngrößenpaare entsprechen. Die Erfindung betrifft auch einen elektromechanischen Antrieb zum Betätigen eines drehbar und/oder verschiebbar an einem Strukturelement gelagerten Flügels, wobei der elektromechanische Antrieb eine Bestimmungseinrichtung aufweist, die zur Durchführung des Verfahrens eingerichtet ist.

{$t_{41}, t_{42}, t_{43}, t_{44}, ...$}
{$t_{51}, t_{52}, t_{53}, t_{54}, ...$}
{$t_{61}, t_{62}, t_{63}, t_{64}, ...$}

Fig. 1

**Beschreibung**

Die Erfindung betrifft ein Verfahren zur Bestimmung mindestens einer Eigenschaft einer Drehbewegung einer dreiphasigen Drehstrommaschine im Generatorbetrieb. Die Erfindung betrifft auch einen elektromechanischen Antrieb zum Betätigen eines drehbar und/oder verschiebbar an einem Strukturelement gelagerten Flügels, insbesondere eines Türflügels oder eines Fensterflügels, wobei der elektromechanische Antrieb eine dreiphasige Drehstrommaschine aufweist, wobei eine Antriebswelle des Drehstrommaschine über eine Kraftübertragungseinrichtung mit dem Flügel in Wirkverbindung steht, wenn der elektromechanische Antrieb bestimmungsgemäß an dem Flügel und/oder dem Strukturelement montiert ist, so dass eine Bewegung der Antriebswelle im Motorbetrieb der Drehstrommaschine eine Bewegung des Flügels bewirkt, wobei eine Bewegung des Flügels im Generatorbetrieb der Drehstrommaschine eine Bewegung der Antriebswelle bewirkt.

Aus dem Stand der Technik sind elektromechanische Antriebe zum Bewegen eines Flügels bekannt. Unter einem Flügel wird dabei insbesondere ein Tür- oder Fensterflügel verstanden. Derartige Flügel sind in den, den Flügel umgebenden Strukturelementen wie beispielsweise Zargen gelagert. Der Flügel stellt also den beweglichen Teil und das Strukturelement den feststehenden Teil dar. Mit dem Begriff der Zarge kann somit auch jedes andere den Flügel umgebende Strukturelement gemeint sein, insbesondere eine Gebäudewand.

Derartige elektromechanische Antriebe weisen häufig einen Elektromotor sowie eine mechanische Schließeinheit auf. Bei der mechanischen Schließeinheit kann es sich beispielsweise um eine Feder handeln, die beim Öffnen des Flügels bzw. beim Bewegen des Flügels in eine Öffnungsrichtung durch den Elektromotor gespannt wird. Zum Schließen des Flügels wird die in der Feder gespeicherte Energie verwendet. Während des Schließvorgangs kann der Elektromotor zum Abbremsen der Flügelbewegung verwendet werden.

Auch im Fehlerfall und insbesondere bei einem Stromausfall soll der Flügel zuverlässig abgebremst werden. Dies betrifft nicht nur den Schließvorgang, sondern im Fehlerfall auch den manuell ausgeführten Öffnungsvorgang, um ein unkontrolliertes Anschlagen in die Öffnungsendlage zu vermeiden.

Um im Fehlerfall den Elektromotor zum Abbremsen verwenden zu können ist es bekannt, Phasen des Elektromotors beispielsweise über Dioden kurzzuschließen. Dreht sich der Elektromotor mit kurzgeschlossener Phase, so wird eine Spannung induziert, wobei der über die Phase fließende Strom ein Bremsmoment bewirkt. Auf diese Weise kann der Elektromotor im Generatorbetrieb als Bremse verwendet werden. Aus der Druckschrift EP 2 267 881 A2 ist es bekannt, die generatorisch erzeugte Energie einem Bipolartransistor als Lastwiderstand zuzuführen. Aus der Druckschrift EP 3 245 732 B1 ist es bekannt, den Phasenkurzschluss derart pulsweitenmoduliert zu steuern, dass sich ein vorgegebener Stromfluss durch die Motorspulen und damit ein vorgegebenes Bremsmoment ergibt.

Zur Steuerung der Bremswirkung im Fehlerfall sind Informationen über die jeweilige Bewegung des Flügels erforderlich. Um den Generatorbetrieb geeignet steuern zu können, müssen insbesondere die Bewegungsrichtung des Flügels sowie die Bewegungsgeschwindigkeit ermittelt werden. Dies kann beispielsweise durch geeignete Sensoren erfolgen.

Als Aufgabe der Erfindung wird es angesehen, die für die Steuerung des Generatorbetriebs erforderlichen Informationen möglichst einfach und energiesparend zu ermitteln sowie einen hierfür geeigneten elektromechanischen Antrieb bereitzustellen.

Diese Aufgabe wird erfindungsgemäß durch ein Verfahren zur Bestimmung mindestens einer Eigenschaft einer Drehbewegung einer dreiphasigen Drehstrommaschine im Generatorbetrieb gelöst, wobei für jede der drei Phasen jeweils eine elektrische Kenngröße für eine Phasenspannung der betreffenden Phase der im Generatorbetrieb erzeugten dreiphasigen Wechselspannung der Drehstrommaschine fortlaufend messtechnisch erfasst wird, wobei aus den drei elektrischen Kenngrößen drei elektrische Kenngrößenpaare gebildet werden, sodass ein erstes elektrisches Kenngrößenpaar die elektrischen Kenngrößen einer ersten und einer zweiten Phase umfasst, ein zweites elektrisches Kenngrößenpaar die elektrischen Kenngrößen der zweiten Phase und einer dritten Phase umfasst und ein drittes elektrisches Kenngrößenpaar die elektrischen Kenngrößen der dritten Phase und der ersten Phase umfasst, wobei fortlaufend jeweils ein Vorzeichen einer Differenz zwischen den elektrischen Kenngrößen jedes Kenngrößenpaars ermittelt wird, und wobei die Eigenschaft der Drehbewegung aus Wechselzeitpunkten ermittelt wird, wobei die Wechselzeitpunkte Zeitpunkten unmittelbar aufeinanderfolgender Vorzeichenwechsel der Differenzen der drei Kenngrößenpaare entsprechen. Auf diese Weise können die für die Steuerung des elektromechanischen Antriebs bzw. der Drehstrommaschine im Generatorbetrieb erforderlichen Informationen mindestens teilweise aus den Phasenspannungen der Drehstrommaschine ermittelt werden. Dabei erfolgt die Bestimmung der Eigenschaft, wie beispielsweise der Bewegungsrichtung oder der Geschwindigkeit, durch die Ermittlung der Zeitpunkte, zu denen die Differenzen der Phasenspannungen bzw. der elektrischen Kenngrößen für die Phasenspannungen einen Vorzeichenwechsel erfahren, also den Nullpunkt durchschreiten. Bei einer Drehstrommaschine im Generatorbetrieb haben die Phasenspannungen der drei Phasen jeweils einen sinusförmigen Verlauf, wobei dieser Verlauf zwischen den Phasen jeweils um 120° verschoben ist. Die Absolutwerte der Phasenspannungen der drei Phasen sind bis auf diese Phasenverschiebung nahezu identisch. Die Differenzen aus den Phasenspannungen weisen daher wieder einen sinusförmigen Verlauf auf, der symmetrisch um den Wert Null läuft. Die Zeitpunkte der Nulldurchgänge bzw. der Vorzeichenwechsel können besonders einfach und energiesparend ermittelt werden und eignen sich gut für die Bestimmung der Bewegungsrichtung und der Bewegungsgeschwindigkeit. Die elektrischen Kenngrößen für die Phasenspannungen stellen ein Maß für die Phasenspannungen dar und müssen für die Bestimmung der mindestens einen Eigenschaft nicht auf einen tatsächlichen Spannungswert beispielsweise in der Einheit Volt umgerechnet werden. So können vorteilhafterweise beispielsweise direkt durch die Verwendung von Hall-Sensoren oder dergleichen ermittelte Spannungswerte für die Bildung der Differenzen und die Ermittlung der Wechselzeitpunkte verwendet werden. Dies erspart einen weiteren Berechnungsschritt und stellt damit eine energieeffiziente Möglichkeit zur Bestimmung der mindestens einen Eigenschaft dar.

Um die Bewegungsrichtung besonders einfach ermitteln zu können ist erfindungsgemäß vorgesehen, dass die Eigenschaft der Drehbewegung eine Drehrichtung der Drehstrommaschine ist, wobei die Drehrichtung aus einer durch die Wechselzeitpunkte bestimmten zeitlichen Reihenfolge der Vorzeichenwechsel der drei Kenngrößenpaare ermittelt wird. Die elektrischen Kenngrößen für die Phasenspannungen $U_1$, $U_2$, $U_3$ verlaufen sinusförmig und 120° phasenverschoben zueinander. Die Differenzen der aus den elektrischen Kenngrößen ermittelten Kenngrößenpaare $\Delta U_{1,2}$, $\Delta U_{2,3}$, $\Delta U_{3,1}$ verlaufen ebenfalls sinusförmig und 120° phasenverschoben zueinander. Die durch die Wechselzeitpunkte bestimmte zeitliche Reihenfolge der Vorzeichenwechsel der Differenzen der Kenngrößenpaare ist dabei drehrichtungsabhängig. Wird beispielsweise die zeitliche Reihenfolge der Vorzeichenwechsel der Kenngrößenpaare $\Delta U_{1,2}$, $\Delta U_{2,3}$, $\Delta U_{3,1}$ von Plus (+) nach Minus (-) betrachtet, so kann sich in einer Drehrichtung die Reihenfolge $\Delta U_{1,2}$, $\Delta U_{2,3}$, $\Delta U_{3,1}$ einstellen und in der anderen Drehrichtung die Reihenfolge $\Delta U_{1,2}$, $\Delta U_{3,1}$, $\Delta U_{2,3}$ einstellen. Das gleiche gilt für die zeitliche Reihenfolge der Vorzeichenwechsel von Minus (-) nach Plus (+). Durch die Ermittlung der durch die Wechselzeitpunkte bestimmten zeitlichen Reihenfolge der Vorzeichenwechsel kann also einfach die Drehrichtung ermittelt werden.

Vorteilhafterweise ist erfindungsgemäß vorgesehen, dass die Eigenschaft der Drehbewegung ein Drehgeschwindigkeitsmaß der Drehstrommaschine ist, wobei Zeitdifferenzen aus den Wechselzeitpunkten ermittelt werden und das Drehgeschwindigkeitsmaß aus den Zeitdifferenzen ermittelt wird. Die Zeitdifferenzen der Wechselzeitpunkte sind abhängig von einer Drehzahl bzw. der Drehgeschwindigkeit der Drehstrommaschine. Umso schneller ein Rotor der Drehstrommaschine rotiert, umso kürzer werden die Zeitdifferenzen. Dabei ist die Drehgeschwindigkeit unmittelbar proportional zu den Zeitdifferenzen. Daher kann aus den Zeitdifferenzen ein Maß für die Drehgeschwindigkeit, das Drehgeschwindigkeitsmaß, ermittelt werden.

Um die Drehgeschwindigkeit möglichst exakt zu ermitteln, ist erfindungsgemäß vorgesehen, dass die Eigenschaft der Drehbewegung eine Drehgeschwindigkeit der Drehstrommaschine ist, wobei die Drehgeschwindigkeit aus dem Drehgeschwindigkeitsmaß und einer Polpaarzahl der Drehstrommaschine ermittelt wird. Eine Anzahl vollständiger Perioden des bei einer Umdrehung des Rotors der Drehstrommaschine in jeder Phase der Drehstrommaschine induzierten sinusförmigen Phasenspannungsverlaufs hängt von der Polpaarzahl der Drehstrommaschine ab. Daher ist auch die Anzahl der Wechselzeitpunkte bei einer vollständigen Umdrehung des Rotors von der Polpaarzahl abhängig. Wird bei der Berechnung neben den Zeitdifferenzen zwischen den Wechselzeitpunkten auch die Polpaarzahl berücksichtigt, kann die Drehgeschwindigkeit ermittelt werden.

Vorteilhafterweise ist erfindungsgemäß vorgesehen, dass die Drehgeschwindigkeit $\omega$ aus einer Zeitdifferenz $\Delta t$ und der Polpaarzahl $p$ der Drehstrommaschine nach folgender Berechnungsvorschrift ermittelt wird:

$$\omega = \frac{\frac{360°}{6p}}{\Delta t}$$

Um die Genauigkeit der ermittelten Drehgeschwindigkeit weiter zu verbessern ist erfindungsgemäß vorgesehen, dass die Eigenschaft eine mittlere Drehgeschwindigkeit ist, wobei die mittlere Drehgeschwindigkeit ein Mittelwert mehrerer nach einem der voranstehend beschriebenen Verfahren ermittelter Drehgeschwindigkeitsmaße oder Drehgeschwindigkeiten ist. Durch die Mittelwertbildung können Abweichungen, die beispielsweise durch eine Abtastfrequenz der elektrischen Kenngrößen resultieren, ausgeglichen werden.

Vorteilhafterweise ist erfindungsgemäß vorgesehen, dass Differenzen der Kenngrößenpaare $\Delta U_{1,2}$, $\Delta U_{2,3}$, $\Delta U_{3,1}$ der elektrischen Kenngrößen für die Phasenspannungen $U_1$, $U_2$, $U_3$ zu Bestimmungszeitpunkten $t$ nach folgenden Berechnungsvorschriften ermittelt werden:

$$\Delta U_{1,2}(t) = U_1(t) - U_2(t)$$

$$\Delta U_{2,3}(t) = U_2(t) - U_3(t)$$

$$\Delta U_{3,1}(t) = U_3(t) - U_1(t)$$

Bei einer besonders vorteilhaften Ausgestaltung des erfindungsgemäßen Verfahrens ist vorgesehen, dass die Vorzeichen der Differenzen durch einen elektronischen Komparator ermittelt werden. Mit Hilfe von Komparatoren können die Vorzeichen der Differenzen direkt ohne explizite Bestimmung der Differenzen ermittelt werden. Dies stellt eine besonders effiziente Ausgestaltung des Verfahrens dar. Vorteilhafterweise können hierfür bereits in einem für die Durchführung des Verfahrens vorgesehene Microcontroller integrierten Komparatoren verwendet werden.

Vorteilhafterweise erfolgt die fortlaufende Bestimmung der Differenzen und/oder der Vorzeichen der Differenzen in vorgegebenen Zeitabständen. Das Verfahren wird vorteilhafterweise digitalelektronisch durchgeführt, sodass eine Abtastung der elektrischen Kenngröße in vorgegebenen Abständen bzw. mit einer Abtastfrequenz erforderlich ist. Durch die Abtastung der elektrischen Kenngrößen und die Verwendung der Komparatoren eines Microcontrollers kann das Verfahren besonders energieeffizient ausgestaltet werden, da die Komparatoren zwischen den Abtastzeitpunkten nicht verwendet werden.

Vorteilhafterweise ist erfindungsgemäß vorgesehen, dass die vorgegebenen Zeitabstände so vorgegeben werden, dass die mindestens eine Eigenschaft mit einer Genauigkeit von mindestens 10% ermittelt wird. Ein durch die vorgegebenen Zeitpunkte bzw. die Abtastrate hervorgerufener relativer Fehler $\omega_{err}$ der Geschwindigkeitsermittlung der Drehgeschwindigkeit $\omega$, aus dem die Genauigkeit der Geschwindigkeitsermittlung bestimmt werden kann, kann in Abhängigkeit der Abtastrate $f_{sample}$, der vorgegebenen Zeitabstände

$$\Delta_t = \frac{1}{f_{sample}}$$

und der Polpaarzahl p folgendermaßen bestimmt werden:

Maximale Messfehler:
Drehgeschwindigkeit      mit      Messfehler:

$$\Delta t, err = \pm \frac{2}{f_{sample}}$$

$$\omega_{ges} = \frac{((360°)/6p)}{(\Delta t + \Delta t_{err})}$$

Relativer Messfehler: $\omega_{err} = \frac{\omega_{ges}}{\omega} - 1$

Die eingangs gestellt Aufgabe wird auch durch einen elektromechanischen Antrieb zum Betätigen eines drehbar und/oder verschiebbar an einem Strukturelement gelagerten Flügels, insbesondere eines Türflügels oder eines Fensterflügels gelöst, wobei der elektromechanische Antrieb eine dreiphasige Drehstrommaschine aufweist, wobei eine Antriebswelle der Drehstrommaschine über eine Kraftübertragungseinrichtung mit dem Flügel in Wirkverbindung steht, wenn der elektromechanische Antrieb bestimmungsgemäß an dem Flügel und/oder dem Strukturelement montiert ist, so dass eine Bewegung der Antriebswelle im Motorbetrieb der Drehstrommaschine eine Bewegung des Flügels bewirkt, wobei eine Bewegung des Flügels im Generatorbetrieb der Drehstrommaschine eine Bewegung der Antriebswelle bewirkt, wobei der elektromechanische Antrieb eine Bestimmungseinrichtung aufweist, wobei die Bestimmungseinrichtung für jede der drei Phasen Messelemente zur Erfassung jeweils einer elektrischen Kenngröße für eine Phasenspannung der betreffenden Phase des im Generatorbetrieb erzeugten dreiphasigen Drehstroms der Drehstrommaschine aufweist, wobei die Messelemente datenübertragend kabelgebunden oder kabellos mit einer elektronischen Auswerteeinheit der Bestimmungseinrichtung verbunden sind, wobei die Bestimmungseinrichtung zur Durchführung des vorangehend beschriebenen Verfahrens eingerichtet ist. Bei den Messelementen kann es sich vorteilhafterweise um Hall-Sensoren handeln.

Die Auswerteeinheit ist vorteilhafterweise ein Mikrocontroller.

Vorteilhafterweise ist erfindungsgemäß vorgesehen, dass der Mikrocontroller integrierte Komparatoren aufweist und die Messelemente elektrisch leitend mit Komparatoreingängen der Komparatoren des Mikrocontrollers verbunden sind. Die integrierten Komparatoren können zur direkten Bestimmung der Vorzeichen in vorgegebenen Zeitabständen verwendet werden. Auf diese Weise kann das erfindungsgemäße Verfahren besonders energieeffizient ausgeführt werden.

Vorteilhafterweise ist erfindungsgemäß vorgesehen, dass es sich bei der Drehstrommaschine um eine Axial- oder eine Radialflussmaschine handelt. Axial- oder Radialflussmaschinen eignen sich besonders gut für die Verwendung mit Tür- oder Fensterantrieben.

Erfindungsgemäß ist vorteilhafterweise vorgesehen, dass es sich bei dem elektromechanischen Antrieb um einen Schwenktürflügel- oder Schiebetür- oder Karusselltürantrieb handelt.

Weitere vorteilhafte Ausgestaltungen des erfindungsgemäßen Verfahrens und des erfindungsgemäßen elektromechanischen Antriebs werden anhand von in der Zeichnung dargestellten Ausführungsbeispielen näher erläutert.

Es zeigt:

Figur 1 drei Diagramme mit schematisch dargestellten Verläufen von Phasenspannungen einer Drehstrommaschine im Generatorbetrieb sowie die Ermittlung von Wechselzeitpunkten und

Figur 2 eine schematisch dargestellte Schnittansicht eines elektromechanischen Antriebs, bei dem das erfindungsgemäße Verfahren verwendet werden kann.

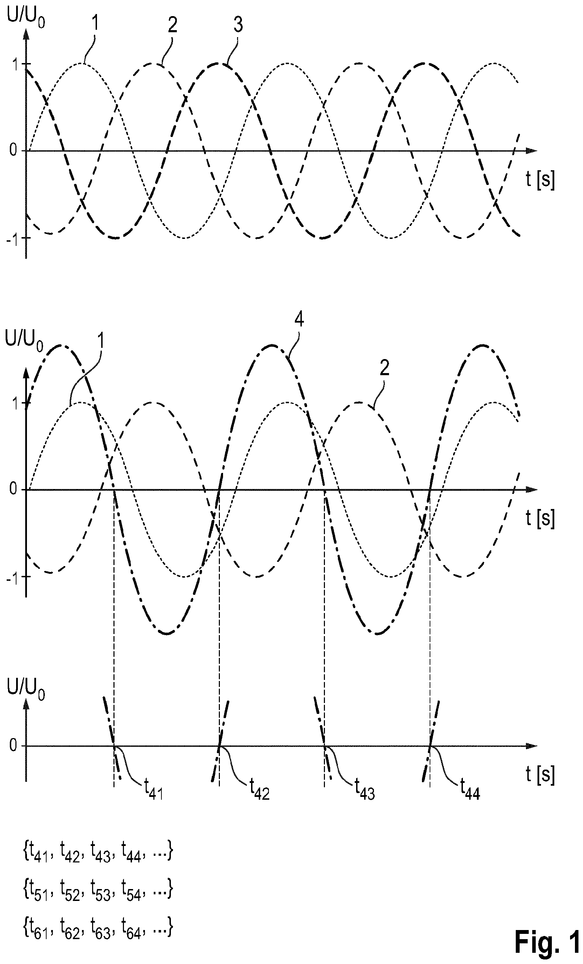

Figur 1 zeigt in dem ersten Diagramm schematisch dargestellte zeitliche Verläufe von Phasenspannungen 1, 2, 3 von Phasen einer dreiphasigen Drehstrommaschine im Generatorbetrieb. Die Phasenspannungen 1, 2, 3 weisen jeweils einen sinusförmigen Verlauf auf und sind dabei um 120° zueinander phasenverschoben.

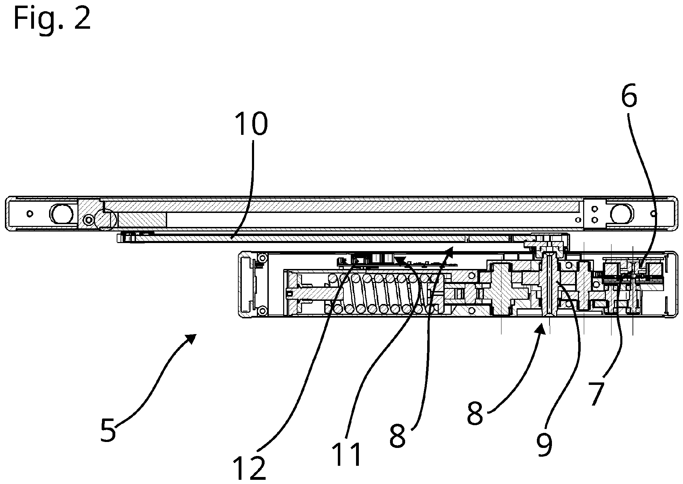

In dem zweiten Diagramm der Figur 1 sind die Phasenspannungen 1 und 2 aus Figur 1 dargestellt sowie die Differenz 4 zwischen den beiden Phasenspannungen 1 und 2. Diese Differenz 4 hat ebenfalls wieder einen sinusförmigen Verlauf mit einer größeren Amplitude als die Phasenspannungen 1 und 2. Sofern die Phasenspannungen 1 und 2 die gleichen Amplituden aufweisen, wäre die Amplitude der Differenz 4 um $\sqrt{3}$ mal größer als die Amplitude der Phasenspannungen 1 und 2. In Figur 2 ist der Übersicht halber nur die Differenz 4 zwischen den Phasenspannungen 1 und 2 dargestellt. Der Verlauf der Differenzen zwischen den Phasenspannungen 2 und 3 sowie 3 und 1 entspricht jeweils dem Verlauf der Differenz 4 phasenverschoben um 120° bzw. 240°.

Für die Bestimmung der Eigenschaften einer Drehbewegung der dreiphasigen Drehstrommaschine im Generatorbetrieb werden Wechselzeitpunkte $t_{4,1}$, $t_{4,2}$, $t_{4,3}$, ... der Differenz 4 sowie Wechselzeitpunkte $t_{5,1}$, $t_{5,2}$, $t_{5,3}$, ... und $t_{6,1}$, $t_{6,2}$, $t_{6,3}$, ... der nicht dargestellten Differenzen herangezogen, wobei die Wechselzeitpunkte Zeitpunkten unmittelbar aufeinanderfolgender Vorzeichenwechsel der Differenzen 4 der drei Kenngrößenpaare entsprechen. Sofern die Ermittlung der Wechselzeitpunkte kontinuierlich oder mit einer ausreichend großen Abtastfrequenz erfolgt, entsprechen die Wechselzeitpunkte den Zeitpunkten der Nulldurchgänge der Differenzen 4, wie dies in dem dritten Diagramm der Figur 1 schematisch anhand der Nulldurchgänge der in dem zweiten Diagramm dargestellten Differenz 4 veranschaulicht ist. In der Figur 1 werden die Wechselzeitpunkte $t_{4,1}$ ... , $t_{5,1}$ ... und $t_{6,1}$ ... als t_41..., t_51 ... und t_61 dargestellt.

In Figur 2 ist schematisch eine Schnittansicht eines elektromechanischen Antriebs 5 zum Betätigen eines drehbar und/oder verschiebbar an einem Strukturelement gelagerten Flügels, insbesondere eines Türflügels oder eines Fensterflügels dargestellt. Der elektromechanische Antrieb 5 weist eine dreiphasige Drehstrommaschine 6 auf, die als Axialflussmaschine ausgestaltet ist. Eine Antriebswelle 7 der Drehstrommaschine 6 steht über eine Kraftübertragungseinrichtung 8 mit dem nicht dargestellten Flügel in Wirkverbindung. Die Kraftübertragungsvorrichtung 8 besteht im Wesentlichen aus einem mit der Drehstrommaschine 6 verbundenen Getriebe 9 und einem Hebel 10. Hierüber wird eine Bewegung der Antriebswelle 7 im Motorbetrieb der Drehstrommaschine 6 in eine Bewegung des Flügels umgesetzt. Eine Bewegung des Flügels im Generatorbetrieb der Drehstrommaschine 6 bewirkt über die Kraftübertragungsvorrichtung 8 eine Bewegung der Antriebswelle 7. Der elektromechanische Antrieb 5 weist zudem eine Bestimmungseinrichtung 11 mit einer Auswerteeinheit 12 und nicht dargestellten und datenübertragend mit der Auswerteeinheit 12 verbundene Messelemente auf. Mit den Messelementen wird für jede der drei Phasen der Drehstrommaschine 6 jeweils eine elektrische Kenngröße für eine Phasenspannung der betreffenden Phase des im Generatorbetrieb erzeugten dreiphasigen Drehstroms der Drehstrommaschine 6 bestimmt und von der Auswerteeinheit 12 verarbeitet. Dabei ist die Auswerteinheit 12 so ausgestaltet, dass mit der Auswerteeinheit 12 aus den mit den Messelementen erfassten elektrischen Kenngrößen für die Phasenspannungen eine Eigenschaft der Drehbewegung der Drehstrommaschine 6 im Generatorbetrieb ermittelt werden kann.

## Patentansprüche

1. Verfahren zur Bestimmung mindestens einer Eigenschaft einer Drehbewegung einer dreiphasigen Drehstrommaschine (6) im Generatorbetrieb, wobei für jede der drei Phasen jeweils eine elektrische Kenngröße für eine Phasenspannung (1, 2, 3) der betreffenden Phase der im Generatorbetrieb erzeugten dreiphasigen Wechselspannung der Drehstrommaschine (6) fortlaufend messtechnisch erfasst wird, wobei aus den drei elektrischen Kenngrößen drei elektrische Kenngrößenpaare gebildet werden, sodass ein erstes elektrisches Kenngrößenpaar die elektrischen Kenngrößen einer ersten und einer zweiten Phase umfasst, ein zweites elektrisches Kenngrößenpaar die elektrischen Kenngrößen der zweiten Phase und einer dritten Phase umfasst und ein drittes elektrisches Kenngrößenpaar die elektrischen Kenngrößen der dritten Phase und der ersten Phase umfasst, wobei fortlaufend jeweils ein Vorzeichen einer Differenz (4) zwischen den elektrischen Kenngrößen jedes Kenngrößenpaars ermittelt wird, und wobei die Eigenschaft der Drehbewegung aus Wechselzeitpunkten ($t_{4,1}$, $t_{4,2}$, $t_{4,3}$, ..., $t_{5,1}$, $t_{5,2}$, $t_{5,3}$, ..., $t_{6,1}$, $t_{6,2}$, $t_{6,3}$, ...) ermittelt wird, wobei die Wechselzeitpunkte ($t_{4,1}$, $t_{4,2}$, $t_{4,3}$, ..., $t_{5,1}$, $t_{5,2}$, $t_{5,3}$, ..., $t_{6,1}$, $t_{6,2}$, $t_{6,3}$, ...) Zeitpunkten unmittelbar aufeinanderfolgender Vorzeichenwechsel der Differenzen der drei Kenngrößenpaare entsprechen.

2. Verfahren gemäß Anspruch 1, **dadurch gekennzeichnet, dass** die Eigenschaft der Drehbewegung eine Drehrichtung der Drehstrommaschine (6) ist, wobei die Drehrichtung aus einer durch die Wechselzeitpunkte ($t_{4,1}$, $t_{4,2}$, $t_{4,3}$, ..., $t_{5,1}$, $t_{5,2}$, $t_{5,3}$, ..., $t_{6,1}$, $t_{6,2}$, $t_{6,3}$, ...) bestimmten zeitlichen Reihenfolge der Vorzeichenwechsel der drei Kenngrößenpaare ermittelt wird.

3. Verfahren gemäß Anspruch 1 oder Anspruch 2, **dadurch gekennzeichnet, dass** die Eigenschaft der Drehbewegung ein Drehgeschwindigkeitsmaß der Drehstrommaschine (6) ist, wobei Zeitdifferenzen aus den Wechselzeitpunkten ($t_{4,1}$, $t_{4,2}$, $t_{4,3}$, ..., $t_{5,1}$, $t_{5,2}$, $t_{5,3}$, ..., $t_{6,1}$, $t_{6,2}$, $t_{6,3}$, ...) ermittelt werden und das Drehgeschwindigkeitsmaß aus den Zeitdifferenzen und einer Polpaarzahl der Drehstrommaschine (6) ermittelt wird.

4. Verfahren gemäß Anspruch 3, **dadurch gekennzeichnet, dass** die Eigenschaft der Drehbewegung eine Drehgeschwindigkeit der Drehstrommaschine (6) ist, wobei die Drehgeschwindigkeit aus dem Drehgeschwindigkeitsmaß und einer Polpaarzahl der Drehstrommaschine (6) ermittelt wird.

5. Verfahren gemäß Anspruch 4, **dadurch gekennzeichnet, dass** die Drehgeschwindigkeit ω aus einer Zeitdifferenz Δt und der Polpaarzahl p der Drehstrommaschine (6) nach folgender Berechnungsvorschrift ermittelt wird:

$$\omega = \frac{\frac{360°}{6p}}{\Delta t}$$

6. Verfahren gemäß einem der Ansprüche 3 bis 5, **dadurch gekennzeichnet, dass** die Eigenschaft eine mittlere Drehgeschwindigkeit ist, wobei die mittlere Drehgeschwindigkeit ein Mittelwert mehrerer nach einem der Ansprüche 3 bis 5 ermittelter Drehgeschwindigkeitsmaße oder Drehgeschwindigkeiten ist.

7. Verfahren gemäß einem der voranstehenden Ansprüche, **dadurch gekennzeichnet, dass** Differenzen 4 der Kenngrößenpaare $\Delta U_{1,2}$, $\Delta U_{2,3}$, $\Delta U_{3,1}$ der elektrischen Kenngrößen für die Phasenspannungen $U_1$, $U_2$, $U_3$ zu Bestimmungszeitpunkten t nach folgenden Berechnungsvorschriften ermittelt werden:

$$\Delta U_{1,2}(t) = U_1(t) - U_2(t)$$

$$\Delta U_{2,3}(t) = U_2(t) - U_3(t)$$

$$\Delta U_{3,1}(t) = U_3(t) - U_1(t)$$

8. Verfahren gemäß einem der voranstehenden Ansprüche, **dadurch gekennzeichnet, dass** die Vorzeichen der Differenzen 4 durch einen elektronischen Komparator ermittelt werden.

9. Verfahren gemäß einem der voranstehenden Ansprüche, **dadurch gekennzeichnet, dass** die fortlaufende Bestimmung der Differenzen 4 und/oder der Vorzeichen der Differenzen 4 in vorgegebenen Zeitabständen erfolgt.

10. Verfahren gemäß Anspruch 9, **dadurch gekennzeichnet, dass** die vorgegebenen Zeitabstände so vorgegeben werden, dass die mindestens eine Eigenschaft mit einer Genauigkeit von mindestens 10% ermittelt wird.

11. Elektromechanischer Antrieb (5) zum Betätigen eines drehbar und/oder verschiebbar an einem Strukturelement gelagerten Flügels, insbesondere eines Türflügels oder eines Fensterflügels, wobei der elektromechanische Antrieb (5) eine dreiphasige Drehstrommaschine (6) aufweist, wobei eine Antriebswelle (7) der Drehstrommaschine (6) über eine Kraftübertragungseinrichtung (8) mit dem Flügel in Wirkverbindung steht, wenn der elektromechanische Antrieb (5) bestimmungsgemäß an dem Flügel und/oder dem Strukturelement montiert ist, so dass eine Bewegung der Antriebswelle (7) im Motorbetrieb der Drehstrommaschine (6) eine Bewegung des Flügels bewirkt, wobei eine Bewegung des Flügels im Generatorbetrieb der Drehstrommaschine (6) eine Bewegung der Antriebswelle (7) bewirkt, **dadurch gekennzeichnet, dass** der elektromechanische Antrieb (5) eine Bestimmungseinrichtung (11) aufweist, wobei die Bestimmungseinrichtung (11) für jede der drei Phasen Messelemente zur Erfassung jeweils einer elektrischen Kenngröße für eine Phasenspannung (1, 2, 3) der betreffenden Phase des im Generatorbetrieb erzeugten dreiphasigen Drehstroms der Drehstrommaschine (6) aufweist, wobei die Messelemente datenübertragend kabelgebunden oder kabellos mit einer elektronischen Auswerteeinheit (12) der Bestimmungseinrichtung (11) verbunden sind, wobei die Bestimmungseinrichtung (11) zur Durchführung des Verfahrens gemäß einem der Ansprüche 1 bis 7 eingerichtet ist.

12. Elektromechanischer Antrieb (5) gemäß Anspruch 11, **dadurch gekennzeichnet, dass** die Auswerteeinheit (12) ein Mikrocontroller ist.

13. Elektromechanischer Antrieb (5) gemäß Anspruch 12, **dadurch gekennzeichnet, dass** der Mikrocontroller integrierte Komparatoren aufweist und die Messelemente elektrisch leitend mit Komparatoreingängen der Komparatoren des Mikrocontrollers verbunden sind.

14. Elektromechanischer Antrieb (5) gemäß einem der Ansprüche 11 bis 13, **dadurch gekennzeichnet, dass** es sich bei der Drehstrommaschine (6) um eine Axial- oder eine Radialflussmaschine handelt.

15. Elektromechanischer Antrieb (5) gemäß einem der Ansprüche 11 bis 14, **dadurch gekennzeichnet, dass** es sich bei dem elektromechanischen Antrieb (5) um einen Schwenktürflügel- oder Schiebetüroder Karusselltürantrieb handelt.

$$\{t_{41}, t_{42}, t_{43}, t_{44}, \ldots\}$$

$$\{t_{51}, t_{52}, t_{53}, t_{54}, \ldots\}$$

$$\{t_{61}, t_{62}, t_{63}, t_{64}, \ldots\}$$

**Fig. 1**

Fig. 2

Europäisches
Patentamt

European
Patent Office

Office européen
des brevets

# EUROPÄISCHER RECHERCHENBERICHT

**Nummer der Anmeldung**

EP 22 20 0303

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2018/248502 A1 (RICHARDS BRYN GEOFFREY RODDICK [GB] ET AL) 30. August 2018 (2018-08-30) | 1-9, 11-15 | INV. H02P3/18 H02P6/182 H02P23/14 |
| Y | * das ganze Dokument * ----- | 1-15 | |
| Y | DE 10 2014 212554 A1 (SIEMENS AG [DE]) 31. Dezember 2015 (2015-12-31) * das ganze Dokument * ----- | 1-15 | |
| A | US 2007/247099 A1 (LU HAIHUI [CN] ET AL) 25. Oktober 2007 (2007-10-25) * das ganze Dokument * ----- | 1-15 | |
| A | US 8 248 005 B2 (ROEMER MARTIN [DE]; DORMA GMBH & CO KG [DE]) 21. August 2012 (2012-08-21) * das ganze Dokument * ----- | 1-15 | |

**RECHERCHIERTE SACHGEBIETE (IPC)**

H02P

Der vorliegende Recherchenbericht wurde für alle Patentansprüche erstellt

| Recherchenort | Abschlußdatum der Recherche | Prüfer |
|---|---|---|
| München | 10. März 2023 | Wimböck, Thomas |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
...............................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 20 0303

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-03-2023

| Im Recherchenbericht angeführtes Patentdokument | Datum der Veröffentlichung | Mitglied(er) der Patentfamilie | Datum der Veröffentlichung |
|---|---|---|---|
| US 2018248502 A1 | 30-08-2018 | CN 109104894 A | 28-12-2018 |
| | | EP 3338360 A1 | 27-06-2018 |
| | | US 2018248502 A1 | 30-08-2018 |
| | | WO 2017029502 A1 | 23-02-2017 |
| DE 102014212554 A1 | 31-12-2015 | CN 106471729 A | 01-03-2017 |
| | | DE 102014212554 A1 | 31-12-2015 |
| | | EP 3129793 A1 | 15-02-2017 |
| | | WO 2016001037 A1 | 07-01-2016 |
| US 2007247099 A1 | 25-10-2007 | CN 101064493 A | 31-10-2007 |
| | | EP 1850471 A2 | 31-10-2007 |
| | | US 7227326 B1 | 05-06-2007 |
| | | US 2007247099 A1 | 25-10-2007 |
| US 8248005 B2 | 21-08-2012 | DE 102009030225 A1 | 30-12-2010 |
| | | EP 2267881 A2 | 29-12-2010 |
| | | US 2010320944 A1 | 23-12-2010 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2267881 A2

- EP 3245732 B1